Europäisches Patentamt

European Patent Office

Office européen des brevets

(11) Veröffentlichungsnummer: **0 415 053 A1**

# EUROPÄISCHE PATENTANMELDUNG

(21) Anmeldenummer: 90113708.3

(51) Int. Cl.⁵: **H05K 5/02**, F15B 15/28

(22) Anmeldetag: 18.07.90

(30) Priorität: 23.08.89 DE 8910094 U

(43) Veröffentlichungstag der Anmeldung:
06.03.91 Patentblatt 91/10

(84) Benannte Vertragsstaaten:
**DE FR GB IT SE**

(71) Anmelder: **ROBERT BOSCH GMBH**
**Postfach 10 60 50**
**W-7000 Stuttgart 10(DE)**

(72) Erfinder: **Müller, Rolf, Dipl.-Ing.**
**Kanalstrasse 8**
**W-7121 Pleidelsheim(DE)**
Erfinder: **Kleiner, Eberhard**
**Teckstrasse 55**
**W-7141 Möglingen(DE)**

(54) **Arbeitsgerät mit in einem Gehäuse verschiebbaren Körper.**

(57) Das Arbeitsgerät mit in einem Gehäuse verschiebbaren Körper hat z. B. an den beiden Enden an seiner Außenseite je einen Zylinderschalter (11, 12), welche Schalter durch ein vergossenes Kabel (13) miteinander verbunden sind. An einem der Zylinderschalter (12) ist ein Kabel (14) mit Stecker (15) angebracht, der in ein elektrisches Auswertegerät (16) einsteckbar ist.

# FIG.1

EP 0 415 053 A1

# ARBEITSGERÄT MIT IN EINEM GEHÄUSE VERSCHIEBBAREN KÖRPER

Stand der Technik

Die Erfindung betrifft ein Arbeitsgerät nach der Gattung des Hauptanspruchs. Bei bekannten Geräten dieser Art ist die Montage der Signalgeber und Befehlsempfänger relativ aufwendig und umständlich.

Vorteile der Erfindung

Das erfindungsgemäße Arbeitsgerät mit den kennzeichnenden Merkmalen des Hauptanspruchs hat demgegenuber den Vorteil, daß es sehr einfach in der Herstellung und Handhabung ist.

Zeichnung

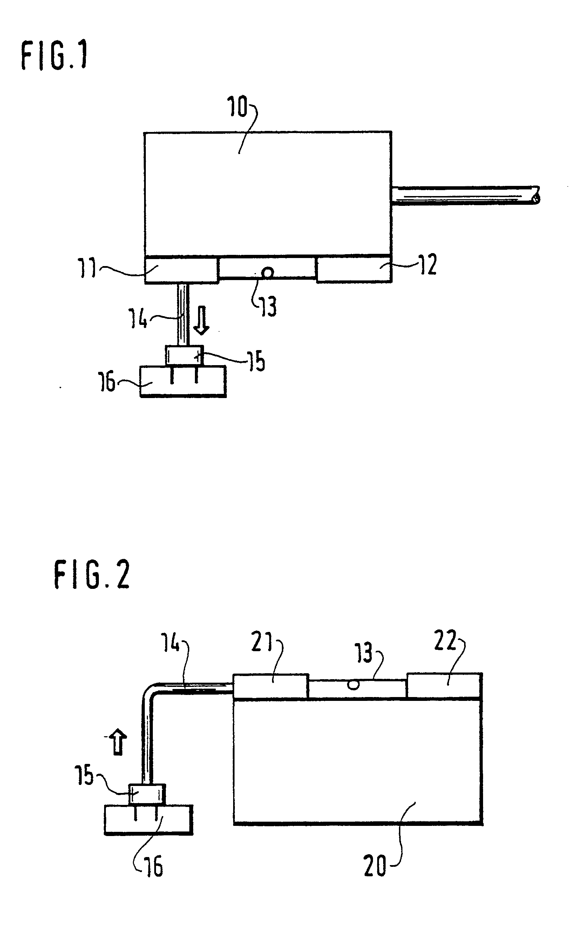

Zwei Ausführungsbeispiele der Erfindung sind in der nachfolgenden Beschreibung und Zeichnung in den Figuren 1 und 2 etwas vereinfacht wiedergegeben.

Beschreibung der Erfindungsbeispiele

In Figur 1 ist mit 10 ein Arbeitszylinder bezeichnet, an dessen Außenseite an den beiden entgegengesetzten Enden je ein elektrischer Zylinderschalter 11, 12 angeordnet ist, welche Zylinderschalter mittels eines mit diesen vergossenen Kabels 13 miteinander verbunden sind. An einem der Zylinderschalter ist ein Kabel 14 mit Stecker 15 angebracht, welcher in einen Datenbus 16 eingesteckt werden kann. Dieser ist so ausgebildet, daß er die Endstellungen des im Arbeitszylinder gleitenden Kolbens erfaßt.

Beim Ausführungsbeispiel nach Figur 2 handelt es sich um ein Steuerventil 20, in dem ein nicht dargestellter Steuerschieber geführt ist. An den Magnetspulen des Steuerventils sind sogenannte elektrische Kupplungsdosen 21, 22 angeordnet, die mittels eines mit diesen vergossenen Kabels 23 verbunden sind. An einer der Kupplungsdosen 21 ist ein Kabel 24 mit Stecker 25 befestigt, welcher wiederum in einen Datenbus 26 zwecks Befehlsgabe für die Magnetspulen zum Betätigen des Ventils eingesteckt werden kann.

Auf diese Weise erhält man eine einfache und schnelle Montage der elektrischen Verbindungen. Bisher mußten die elektrischen Verbindungen einzeln und zeitaufwendig hergestellt werden.

Der Erfindungsgegenstand kann auch so ausgebildet sein, daß an einem bestimmten Gerät nur eine Endstellung des verschiebbaren Körpers ermittelt werden soll bzw. nur eine Magnetspule erregt werden soll. In diesem Fall ist natürlich nur ein Zylinderschalter bzw. Kupplungsdose notwendig.

Ansprüche

1. Arbeitsgerät mit in einem Gehäuse verschiebbaren Körper, wie z. B. Arbeitszylinder, Schieberventil oder dergleichen und mit elektrischen Mitteln (11, 12; 15, 16) zur Feststellung der Stellung bzw. Positionierung dieses Körpers, dadurch gekennzeichnet, daß die elektrischen Mittel untereinander mit Hilfe fest vergossener Kabel (15) verbunden sind und daß an einem der Mittel ein Kabel (14) mit Stecker (15) angeordnet ist.

2. Arbeitsgerät nach Anspruch 1, dadurch gekennzeichnet, daß die Mittel an beiden Endlagenbereichen an der Außenseite des Gehäuses angeordnet sind.

3. Arbeitsgerät nach Anspruch 1 oder 2, dadurch gekennzeichnet, daß die Mittel Zylinderschalter (11, 12) sind.

4. Arbeitsgerät nach Anspruch 1 oder 2, dadurch gekennzeichnet, daß die Mittel Kupplungsdosen (21, 22) für Magnetspulen sind.

FIG.1

FIG.2

**Europäisches Patentamt**

**EUROPÄISCHER RECHERCHENBERICHT**

Nummer der Anmeldung

**EP 90 11 3708**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | HYDRAULICS & PNEUMATICS Band 39, Nr. 5, Mai 1986, Seiten 56-63,106,107, Cleveland, Ohio, US; E. JACOBS et al.: "Making fluid power cylinders "smart"" * Seite 63, mittlere Spalte, Absätze 1,2; Figur auf Seite 63, linke Spalte oben * | 1 | H 05 K 5/02 F 15 B 15/28 |
| A | idem | 2,3 | |
| Y | US-A-4 286 386  (I.E. LONG) * Spalte 1, Zeilen 10-13; Spalte 6, Zeilen 50-62; Figur 6 * | 1 | |
| A | DE-U-8 307 976  (MURRELEKTRONIK) * Seite 8, Absatz 5; Seite 10, Absatz 3; Figur * | 4 | |
| | | | **RECHERCHIERTE SACHGEBIETE (Int. Cl.5)** |
| | | | H 05 K 5/00 F 15 B 15/00 |

Der vorliegende Recherchenbericht wurde für alle Patentansprüche erstellt

| Recherchenort | Abschlußdatum der Recherche | Prüfer |
|---|---|---|
| Berlin | 28 November 90 | ALEXATOS G |